# EUROPEAN PATENT SPECIFICATION

(11) **EP 2 747 160 B1**
(45) Date of publication and mention of the grant of the patent: **28.08.2019**
(21) Application number: 13167578.7
(22) Date of filing: 14.05.2013
(51) Int. Cl.: H01L 51/54

(54) **Organic light emitting diode**
Organische lichtemittierende Diode
Diode électroluminescente organique

(30) Priority: 21.12.2012 CN 201210566239
(43) Date of publication of application: 25.06.2014
(73) Proprietor: Xiamen Tianma Micro_Electronics Co., Ltd, Xiamen, Xinjiang 361101 (CN)
(72) Inventor: Lin, Wenjing, Haidian District, Beijing 100036 (CN)
(74) Representative: Prinz & Partner mbB

(56) References cited:
- CN-A- 102 651 454
- US-A1- 2008 286 610
- US-A1- 2009 261 360
- US-A1- 2011 291 156
- US-A1- 2011 303 902

## Description

### Technical Field

The present invention relates to the field of photovoltaic technologies, in particular, to an organic light emitting diode.

### Technical Background

An Organic Light Emitting Diode (OLED) emits light if an organic film is applied with a voltage, and is increasingly widely used in flat panel displays, illuminations, and backlights.

Nowadays, a White Organic Light Emitting Diode (WOLED) with a common phosphorescent material possesses poor stability due to the lack of good dark blue phosphorescent material therein. Also, a WOLED of a structure with combined phosphorescence and fluorescence utilizes both singlet excitons and triplet excitons, but the singlet excitons (i.e. fluorescent excitons) are different from the triplet excitons (i.e. phosphorescent excitons) in terms of an energy property and a transfer property, and a charge recombination zone is moved depending on the voltage, so that the WOLED has a complex structure, a low energy utilization and a low light emitting efficiency, and more particularly, an optical spectrums of a WOLED device is severely changed along with the voltage, which leads to a poor color stability.

US 2009/0261360 A1 discloses a light-emitting element including a cathode, an anode, a first light-emitting layer that is disposed between the cathode and the anode and that emits light of a first color, a second light-emitting layer that is disposed between the first light-emitting layer and the cathode and that emits light of a second color different from the first color, a third light-emitting layer that is disposed between the second light-emitting layer and the cathode and that emits light of a third color different from the first color and the second color, a first interlayer that is disposed between the first light-emitting layer and the second light-emitting layer so as to be in contact with the first and second light-emitting layers and that has a function of preventing energy transfer of an exciton between the first light-emitting layer and the second light-emitting layer, and a second interlayer that is disposed between the second light-emitting layer and the third light-emitting layer so as to be in contact with the second and third light-emitting layers and that has a function of preventing energy transfer of an exciton between the second light-emitting layer and the third light-emitting layer, wherein the first interlayer has a hole-transporting property higher than that of the second interlayer, and the second interlayer has an electron-transporting property higher than that of the first interlayer.

US 2011/303902 A1 discloses an organic light-emitting diode with high color rendering, which includes: a substrate; a first electrode disposed over the substrate; a light-emitting region disposed over the first electrode, in which the light-emitting region includes a plurality of light-emitting layers and at least one spacer, the spacer being disposed between any two of the light-emitting layers and each of the light-emitting layers individually including a dye; and a second electrode disposed over the light-emitting region.

CN 102 651 454 A discloses an electroluminescent element, a display device and a method for preparing the electroluminescent element. The electroluminescent element comprises a substrate and an anode layer, a light-emitting layer and a cathode layer that are disposed in sequence on the substrate. At least one insertion layer for adjusting electron mobility is disposed within the light-emitting layer. disposing an insertion layer in the light-emitting layer, shall have the effect that a voltage on the recombination of electrons and holes in the light-emitting layer can be reduced, the level of the recombination of carriers such as electrons and holes in the light-emitting layer can be increased, and the ratio of electrons and holes that are combined can be increased.

US 2008/0286610 A1 discloses an electroluminescent device comprising a cathode and an anode; and located therebetween, a fluorescent light-emitting layer (LEL) comprising at least one fluorescent emitter and a host, together with at least one phosphorescent light-emitting layer comprising at least one phosphorescent emitter and a host, and having a spacer layer interposed between the fluorescent and phosphorescent light-emitting layers. In a specific embodiment, a light emmiting layer comprises a first phosphorescent layer (Ir(ppy)₃ doped TcTa), a first isolation layer including CBP, a blue fluorescent layer, a second isolation layer inlcuding BAIq, and a second phosphorescent layer (Ir(piq)2(acac)). The materials within these layers are selected so that the triplet energy levels of certain components satisfy certain interrelationships.

US 2009/0091255 A1 discloses OLEDs having a first phosphorescent layer, a CBP interlayer, a blue fluorescent layer, a BAIq interlayer and a second phosphorescent layer, aimed at achieving a white light emission.

### Summary of the Invention

An object of the present invention is to propose an OLED with improved color stability.

It is disclosed by the present invention an OLED including a substrate, an anode, a hole transport layer, a light emitting layer, an electron transport layer, and a cathode;
where the light emitting layer comprises a first phosphorescent light emitting layer, a first isolation layer, a blue fluorescent light emitting layer, a second isolation layer, and a second phosphorescent light emitting layer, which are stacked along a direction from the anode to the cathode;
wherein the first isolation layer is a layer of material capable of conducting holes and blocking electrons and made of 4,4',4"-tris(carbazol-9-yl) triphenylamine (TCTA), and the second isolation layer is a layer of material capable of conducting electrons and blocking holes and made of tris-(8-hydroxyquinoline) aluminum (AlQ); and
wherein the first isolation layer has a thickness of 8nm, and the second isolation layer has a thickness of 5nm.

Preferably, the blue fluorescent light emitting layer is an organic light emitting material layer of 4,4'-bis(2,2-diphenylvinyl)biphenyl (DPVBi).

Preferably, the blue fluorescent light emitting layer has a thickness of a range from 5nm to 20nm.

Preferably, the blue fluorescent light emitting layer has a thickness of 10nm.

Preferably, the first and the second phosphorescent light emitting layers are of the same color or different colors.

Preferably, both the first and the second phosphorescent light emitting layers are yellow phosphorescent light emitting layers or red phosphorescent light emitting layers; or
the first and the second phosphorescent light emitting layers are a red phosphorescent light emitting layer and a green phosphorescent light emitting layer, respectively; or
the first and the second phosphorescent light emitting layers are a green phosphorescent light emitting layer and a red phosphorescent light emitting layer, respectively.

Preferably, the green phosphorescent light emitting layer is an organic material layer obtained by doping a guest material of tris(2-phenylpyridine)iridium (Ir(ppy)₃) into a host material of 4,4'-N,N'-dicarbazol-biphenyl (CBP) at a molar ratio of 8%; and
the red phosphorescent light emitting layer is an organic material layer obtained by doping a guest material of tris(2-phenylquinoline)iridium (Ir(2-phq)₃) into a host material of 4,4'-N,N'-dicarbazol-biphenyl (CBP) at a molar ratio of 8%.

Preferably, the green phosphorescent light emitting layer has a thickness of 5-20nm, and the red phosphorescent light emitting layer has a thickness of 5-20nm.

Preferably, the green phosphorescent light emitting layer has a thickness of 10nm, and the red phosphorescent light emitting layer has a thickness of 12nm.

According to the invention, the first isolation layer is made of 4,4',4"-tris(carbazol-9-yl)triphenylamine (TCTA), and the second isolation layer is a made of Tris-(8-hydroxyquinoline)aluminum (AIQ).

The first isolation layer has a thickness of 8nm, and the second isolation layer has a thickness of 5nm.

Preferably, the OLED further includes a hole injection layer provided between the anode and the hole transport layer, and an electron injection layer provided between the cathode and the electron transport layer.

Preferably, the OLED further includes:
a first exciton constraining layer, which is a layer of material capable of conducting holes and blocking electrons and provided between the light emitting layer and the hole transport layer; and
a second exciton constraining layer, which is a layer of material capable of conducting electrons and blocking holes and disposed between the light emitting layer and the electron transport layer.

In the present invention, by providing the isolation layers, current carriers are constrained in the blue fluorescent light emitting layer in which the fluorescent material is used as the light emitting body, that is, the exciton recombination zone is constrained in the blue fluorescent light emitting layer, so that the fluorescent excitons with a short diffusion distance are all utilized by the blue fluorescent light emitting layer and the phosphorescent excitons with a longer diffusion distance are all utilized by the phosphorescent light emitting layer, thereby achieving the isolated distribution of the excitons in corresponding light emitting layers and improving the light emitting efficiency and light stability of the OLED.

### Description of Drawings

Figure 1 is a schematic diagram of the structure of an OLED according to a first embodiment of the present invention;
Figure 2 is a schematic diagram of the structure the OLED according to another implementation of the first embodiment of the present invention;
Figure 3 is a schematic diagram of the structure of the OLED according to a second embodiment of the present invention; and
Figure 4 is a schematic diagram of the structure of the OLED according to a third embodiment of the present invention.

### Detailed description of the Preferred Embodiment

The technical solution of the present invention will be further described by way of embodiments below in conjunction with the accompanying drawings.

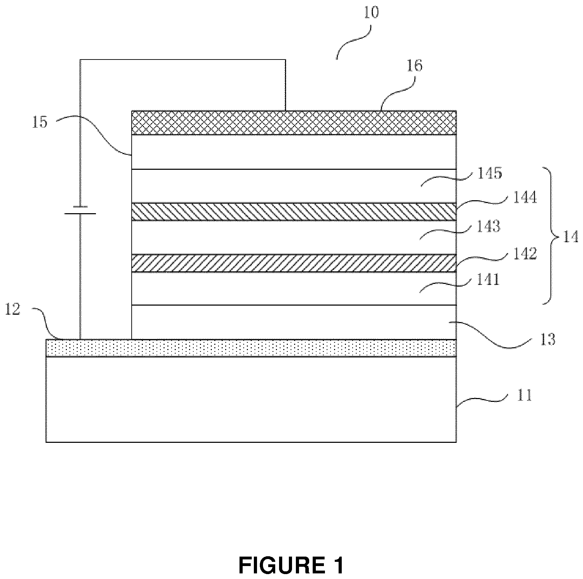

Figure 1 is a schematic diagram of the structure of an OLED according to a first embodiment of the present invention. As shown in Figure 1, the OLED 10 includes a substrate 11, an anode 12, a hole transport layer 13, a light emitting layer 14, an electron transport layer 15, and a cathode 16, which are stacked.

The light emitting layer 14 includes a first phosphorescent light emitting layer 141, a first isolation layer 142, a blue fluorescent light emitting layer 143, a second isolation layer 144, and a second phosphorescent light emitting layer 145, which are stacked along a direction from the anode to the cathode.

The first isolation layer 142 is a layer of material capable of conducting holes and blocking electrons, and the second isolation layer 144 is a layer of material capable of conducting electrons and blocking holes.

When a current is applied to the OLED, holes are injected to the light emitting layer 14 by the anode 12 through the hole transport layer 13, and electrons are injected to the light emitting layer 14 by the cathode 16 through the electron transport layer 15. The injected holes and electrons are respectively transferred towards electrodes with opposite charges. When an electron and a hole are localized at the same molecule, an "exciton", i.e., a localized electron-hole pair of an excited energy state, is formed. Light is emitted due to a radiation transition during the transfer of the exciton from an excited state back to a ground state. When electrons and holes meet each other, their recombination results in excitons, of which 25% are singlet excitons and 75% are triplet excitons. The radiation transition from the excited singlet state to the ground state causes the emission of the fluorescent light, and the radiation transition from the excited triplet state to the ground state causes the emission of the phosphorescent light. The phosphorescent light emitting process is a transition involving the change of spin multiplicity and is constrained by a spin factor, thus its transition rate is much lower than that in the fluorescent emitting process. Accordingly, the triplet exciton can travel a longer distance due to its longer life. Further, the fluorescent material in the organic light emitting material can emit the fluorescent light merely by means of radiation attenuation of the singlet excitons, while the phosphorescent material in the organic light emitting material can emit the phosphorescent light by means of radiation attenuation of the triplet excitons.

In this embodiment, the first isolation layer 142 is designed to be a layer of material capable of conducting holes and blocking electrons, and the second isolation layer 144 is designed to be a layer of material capable of conducing electrons and blocking holes. The first isolation layer 142 is provided at the side of the blue fluorescent light emitting layer 143 away from the cathode, and the second isolation layer 144 is provided at the side of the blue fluorescent light emitting layer 143 away from the anode. Therefore, the holes injected from the anode into the blue fluorescent light emitting layer 143 can be blocked by the second isolation layer 144, and hence cannot be further moved to the cathode; meanwhile, the electrons injected from the cathode into the blue fluorescent light emitting layer 143 can be blocked by the first isolation layer 142, and hence cannot be further moved to the anode, thus, the electrons and the holes are restricted in the blue fluorescent light emitting layer 143 for combination, that is, the exciton recombination zone is constrained in the blue fluorescent light emitting layer 143, so that most excitons are generated in the blue fluorescent light emitting layer 143. In this case, the fluorescent excitons (i.e. singlet excitons) can be utilized by the fluorescent material in the blue fluorescent light emitting layer, since they cannot pass through the isolation layers to reach the phosphorescent light emitting layers due to their short lives. On the contrary, the phosphorescent excitons (i.e. triplet excitons) can be utilized by the phosphorescent material in the phosphorescent light emitting layer, since they can pass through the first or the second isolation layer due to their long lives which lead to long diffusion distances. Therefore, both the singlet excitons and the triplet excitons can be better utilized, thus improving the light emitting efficiency of the device.

In designing the structure of the OLED, the thicknesses of the first isolation layer 142 and the second isolation layer 144 may be adjusted to control the distribution of the excitons (i.e., energy) in the light emitting layer, thereby adjusting the brightness and other color characteristics of various primary colors, in order to achieve the white balance or other desired effect.

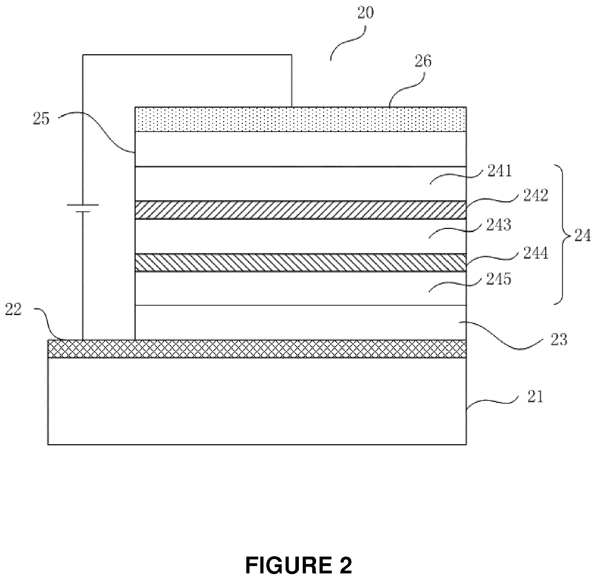

In another implementation of this embodiment, as shown in Figure 2, an OLED 20 includes a substrate 21, a cathode 22, an electron transport layer 23, a light emitting layer 24, a hole transport layer 25, and an anode 26, which are stacked. That is, the anode 26 is located on the top of the OLED 20. The OLED 20 may be referred as an "inverted" OLED, since common OLEDs are mostly constructed with a structure in which the cathode is located above the anode. Correspondingly, the light emitting layer 24 includes a first phosphorescent light emitting layer 241, a first isolation layer 242, a blue fluorescent light emitting layer 243, a second isolation layer 244, and a second phosphorescent light emitting layer 245, which are stacked along a direction from the anode 26 to the cathode 21.

The first isolation layer 242 is a layer of material capable of conducting holes and blocking electrons, and the second isolation layer 244 is a layer of material capable of conducting electrons and blocking holes. In the "inverted" OLED, only corresponding modification and selection of the material constituting the cathode and the anode is required, for example, a metal layer with a thickness of 10-20nm formed by any one or composition of Ag and Mg is employed as a transparent cathode, and a metal layer with a larger thickness formed by any one or composition of Ag and Mg is employed as a semitransparent anode.

In this embodiment, by providing the isolation layers, current carriers are constrained in the blue fluorescent light emitting layer in which the fluorescent material is used as the light emitting body, that is, the exciton recombination zone is constrained in the blue fluorescent light emitting layer, so that the fluorescent excitons with a short diffusion distance are all utilized by the blue fluorescent light emitting layer and the phosphorescent excitons with a longer diffusion distance are all utilized by the phosphorescent light emitting layer, thereby achieving the isolated distribution of the excitons in corresponding light emitting layers and improving the light emitting efficiency and light stability of the OLED.

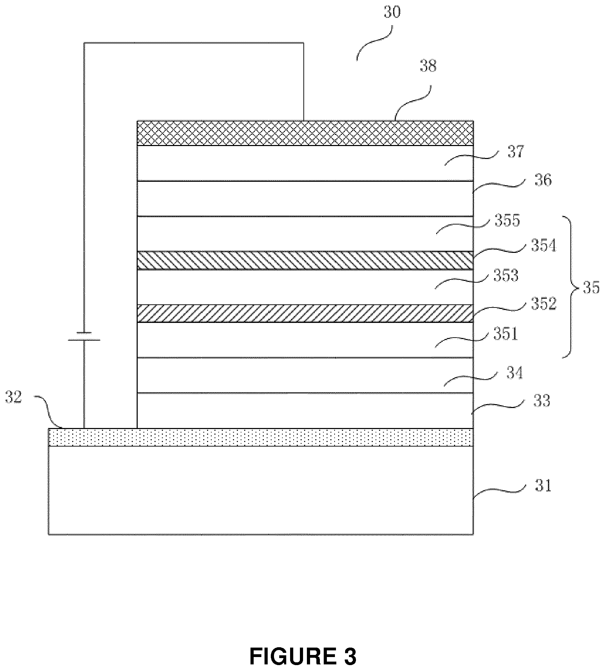

Figure 3 is a schematic diagram of the structure of an OLED according to a second embodiment of the present invention. As shown in Figure 3, the OLED 30 according to the second embodiment of the present invention includes a substrate 31, an anode 32, a hole injection layer 33, a hole transport layer 34, a light emitting layer 35, an electron transport layer 36, an electron injection layer 37, and a cathode 38, which are stacked.

The light emitting layer 35 is formed with a composite structure, which includes a first phosphorescent light emitting layer 351, a first isolation layer 352, a blue fluorescent light emitting layer 353, a second isolation layer 354, and a second phosphorescent light emitting layer 365, which are stacked along a direction from the anode to the cathode.

The first isolation layer 352 is a layer of material capable of conducting holes and blocking electrons, and the second isolation layer 355 is a layer of material capable of conducting electrons and blocking holes.

In the preferred implementation of the present embodiment, the anode 32 is embodied as a film of Indium Tin Oxide (ITO), Indium Zinc Oxide (IZO), or other transparent conductive materials.

The hole injection layer 33 is formed by 4,4',4"-tris(3-methylphenylphenylamino)-triphenylamine (m-MTDATA), and preferably has a thickness of 10nm.

The hole transport layer 34 is formed by 4,4'-cyclohexylidenebis[N,N-bis (4-methylphenyl)aniline] (TAPC), and preferably has a thickness of 30nm.

The electron transport layer 36 and electron injection layer 37 each are formed by 2,9-dimethyl-4,7-diphenyl-1,10-phenanthroline (BCP), and preferably have a thicknesses of 30nm.

The cathode 38 is formed with a composite cathode structure, which is formed preferably by a Lithium Fluoride (LiF) layer having a thickness of 1nm and an Aluminum (Al) layer located thereon.

The light emitting layer 35 is formed with a composite structure and includes a first isolation layer 352, which is formed by 4,4',4"-tris(carbazol-9-yl)triphenylamine (TCTA) and has a thickness of 8nm.

The second isolation layer 355 is formed by tris(8-hydroxyquinoline)aluminum (AIQ), and has a thickness of 5nm.

In designing the structure of the OLED, the thicknesses of the first isolation layer and the second isolation layer may be adjusted to control the distribution of the excitons (i.e., energy) in the light emitting layer, thereby adjusting the brightness and other color characteristics of various primary colors, in order to achieve the white balance or other desired effect.

The first and the second phosphorescent light emitting layers may be of the same color or different colors. In this embodiment, the first phosphorescent light emitting layer is a red phosphorescent light emitting layer, which is formed by an organic material obtained by doping a guest material of tris(2-phenylquinoline)Iridium (Ir(2-phq)₃) into a host material of 4,4'-N,N'-dicarbazol-biphenyl (CBP) at a molar ratio of 8% (i.e., Ir (2-phq)₃ : CBP is 8%), and has a thickness of 5-20nm, and preferably a thickness of 10nm.

The second phosphorescent light emitting layer is a green phosphorescent light emitting layer, which is formed by an organic material obtained by doping a guest material of tris(2-phenylpyridine)iridium (Ir(ppy)₃) into a host material of 4,4'-N,N'-dicarbazol-biphenyl (CBP) at molar ratio of 8% (i.e., Ir(ppy)₃ : CBP is 8%), and has a thickness of 5-20nm, and preferably a thickness of 12nm.

In another implementation, the first and the second phosphorescent light emitting layers may be light emitting layers with a color complementary to blue, for example, yellow or red phosphorescent light emitting layers. If the OLED is intended to emit light of another desired color, the first and the second phosphorescent light emitting layers can also be embodied as primary-color light emitting layers which emit light to be combined with blue color to obtain the desired color.

It should be understood by those skilled in the art that, the materials and thicknesses thereof employed by the above OLEDs are illustrated merely for the exemplary description of the specific implementations of the present invention. Other alternative known materials with the same function may be selected by the skilled in the art based on a limited number of tests to form the corresponding material layers, and the thicknesses of the different layers in the composite light emitting layers may be adjusted to achieve the desired light effect.

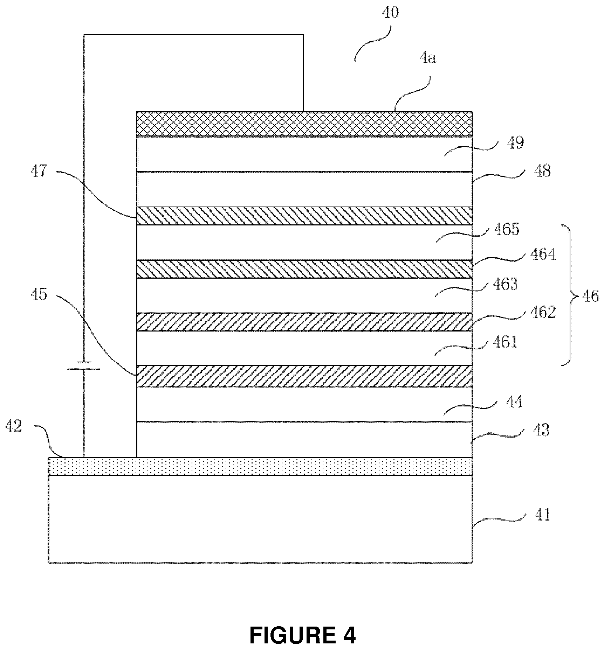

Figure 4 is a schematic diagram of the structure of an OLED according to a third embodiment of the present invention. As shown in Figure 4, the OLED 40 according to the third embodiment of the present invention includes a substrate 41, an anode 42, a hole injection layer 43, a hole transport layer 44, a first exciton constraining layer 45, a light emitting layer 46, a second exciton constraining layer 47, an electron transport layer 48, an electron injection layer 49, and a cathode 4a, which are stacked. That is, the OLED 40 according to the third embodiment is additionally provided with the first exciton constraining layer 45 and the second exciton constraining layer 47 compared with that of the second embodiment. The first exciton constraining layer 45 and the second exciton constraining layer 47 are a layer of material capable of conducting holes and blocking electrons and a layer of material capable of conducting electrons and blocking holes, respectively. Thus, electrons moved from the cathode to the anode in Figure 4, after being subjected to blocking by the first isolation layer of the light emitting layer 46, can also be blocked by the first exciton constraining layer 45 even if passing through the first isolation layer, so that the electrons are recombined with the holes in the light emitting layer 46. Likewise, holes moved from the anode to the cathode in Figure 4, after being subjected to blocking by the second isolation layer of the light emitting layer 46, can also be blocked by the second exciton constraining layer 47 to stay in the light emitting layer 46 for recombining with the electrons even if passing through the second isolation layer. Thereby, the light emitting efficiency of the OLED is further improved.

In this embodiment, by providing the first and the second exciton constraining layers, the exciton recombination zone is further constrained in the light emitting layer, thereby further improving the light emitting efficiency of the OLED.

## Claims

1. An organic light emitting diode, comprising a substrate, an anode, a hole transport layer, a light emitting layer, an electron transport layer, and a cathode, wherein,
the light emitting layer comprises a first phosphorescent light emitting layer, a first isolation layer, a blue fluorescent light emitting layer, a second isolation layer, and a second phosphorescent light emitting layer, which are stacked in that order along a direction from the anode to the cathode;
wherein the first isolation layer is a layer of material capable of conducting holes and blocking electrons and made of 4,4',4"-tris(carbazol-9-yl) triphenylamine (TCTA), and the second isolation layer is a layer of material capable of conducting electrons and blocking holes and made of tris-(8-hydroxyquinoline) aluminum (AlQ); and
wherein the first isolation layer has a thickness of 8nm, and the second isolation layer has a thickness of 5nm.

2. The organic light emitting diode of claim 1, wherein, the blue fluorescent light emitting layer is an organic light emitting material layer of 4,4'-bis(2,2-diphenylvinyl)biphenyl (DPVBi).

3. The organic light emitting diode of claim 2, wherein, the blue fluorescent light emitting layer has a thickness of a range from 5nm to 20nm.

4. The organic light emitting diode of claim 3, wherein, the blue fluorescent light emitting layer has a thickness of 10nm.

5. The organic light emitting diode of claim 1, wherein, the first and the second phosphorescent light emitting layers are of the same color or different colors.

6. The organic light emitting diode of claim 5, wherein, both the first and the second phosphorescent light emitting layers are yellow phosphorescent light emitting layers or red phosphorescent light emitting layers; or
the first and the second phosphorescent light emitting layers are a red phosphorescent light emitting layer and a green phosphorescent light emitting layer, respectively; or
the first and the second phosphorescent light emitting layers are a green phosphorescent light emitting layer and a red phosphorescent light emitting layer, respectively.

7. The organic light emitting diode of claim 6, wherein,
the green phosphorescent light emitting layer is an organic material layer obtained by doping a guest material of tris(2-phenylpyridine)iridium (Ir(ppy)₃) into a host material of 4,4'-N,N'-dicarbazol-biphenyl (CBP) at a molar ratio of 8%; and
the red phosphorescent light emitting layer is an organic material layer obtained by doping a guest material of tris(2-phenylquinoline)iridium (Ir(2-phq)₃) into a host material of 4,4'-N,N'-dicarbazol-biphenyl (CBP) at a molar ratio of 8%.

8. The organic light emitting diode of claim 7, wherein, the green phosphorescent light emitting layer has a thickness of 5-20nm, and the red phosphorescent light emitting layer has a thickness of 5-20nm.

9. The organic light emitting diode of claim 8, wherein, the green phosphorescent light emitting layer has a thickness of 10nm, and the red phosphorescent light emitting layer has a thickness of 12nm.

10. The organic light emitting diode of claim 1, further comprising a hole injection layer provided between the anode and the hole transport layer, and an electron injection layer provided between the cathode and the electron transport layer.

11. The organic light emitting diode of claim 10, further comprising:
a first exciton constraining layer, which is a layer of material capable of conducting holes and blocking electrons and provided between the light emitting layer and the hole transport layer; and
a second exciton constraining layer, which is a layer of material capable of conducting electrons and blocking holes and disposed between the light emitting layer and the electron transport layer.

## Patentansprüche

1. Organische Leuchtdiode, mit einem Substrat, einer Anode, einer Lochtransportschicht, einer lichtaussendenden Schicht, einer Elektronentransportschicht und einer Kathode, wobei
die lichtaussendende Schicht eine erste phosphoreszierende, lichtaussendende Schicht, eine erste Isolierschicht, eine blau fluoreszierende, lichtaussendende Schicht, eine zweite Isolierschicht und eine zweite phosphoreszierende, lichtaussendende Schicht umfasst, die in dieser Reihenfolge längs einer Richtung von der Anode zur Kathode gestapelt sind;
wobei die erste Isolierschicht eine Schicht aus einem Material ist, das in der Lage ist, Löcher zu leiten und Elektronen zu blockieren, und aus 4,4',4"-Tris(carbazol-9-yl)triphenylamin (TCTA) gebildet ist, und die zweite Isolierschicht eine Schicht aus einem Material ist, das in der Lage ist, Elektronen zu leiten und Löcher zu blockieren, und aus Tris-(8-hydroxy)aluminium (AIQ) gebildet ist; und
wobei die erste Isolierschicht eine Dicke von 8 nm und die zweite Isolierschicht eine Dicke von 5 nm aufweist.

2. Organische Leuchtdiode nach Anspruch 1, wobei die blau fluoreszierende, lichtaussendende Schicht eine organische lichtaussendende Materialschicht aus 4,4'-Bis(2,2-diphenylvinyl)biphenyl (DPVBi) ist.

3. Organische Leuchtdiode nach Anspruch 2, wobei die blau fluoreszierende, lichtaussendende Schicht eine Dicke in einem Bereich von 5 nm bis 20 nm aufweist.

4. Organische Leuchtdiode nach Anspruch 3, wobei die blau fluoreszierende, lichtaussendende Schicht eine Dicke von 10 nm aufweist.

5. Organische Leuchtdiode nach Anspruch 1, wobei die erste und die zweite phosphoreszierende, lichtaussendende Schicht die gleiche Farbe oder unterschiedliche Farben aufweisen.

6. Organische Leuchtdiode nach Anspruch 5, wobei sowohl die erste als auch die zweite phosphoreszierende, lichtaussendende Schicht gelb phosphoreszierende, lichtaussendende Schichten oder rot phosphoreszierende, lichtaussendende Schichten sind; oder
die erste und die zweite phosphoreszierende, lichtaussendende Schicht eine rot phosphoreszierende, lichtaussendende Schicht bzw. eine grün phosphoreszierende, lichtaussendende Schicht sind; oder
die erste und die zweite phosphoreszierende, lichtaussendende Schicht eine grün phosphoreszierende, lichtaussendende Schicht bzw. eine rot phosphoreszierende, lichtaussendende Schicht sind.

7. Organische Leuchtdiode nach Anspruch 6, wobei
die grün phosphoreszierende, lichtaussendende Schicht eine Schicht aus organischem Material ist, die durch Dotieren eines Gastmaterials aus Tris(2-phenylpyridin)iridium (Ir(ppy)₃) in ein Grundmaterial aus 4,4'-N,N'-Dicarbazol-biphenyl (CBP) in einem Molverhältnis von 8% erhalten ist; und
die rot phosphoreszierende, lichtaussendende Schicht eine Schicht aus organischem Material ist, die durch Dotieren eines Gastmaterials aus Tris(2-phenylchinolin)iridium (Ir(2-phq)₃) in ein Grundmaterial aus 4,4'-N,N'-Dicarbazol-biphenyl (CBP) in einem Molverhältnis von 8% erhalten ist.

8. Organische Leuchtdiode nach Anspruch 7, wobei die grün phosphoreszierende, lichtaussendende Schicht eine Dicke von 5-20 nm und die rot phosphoreszierende, lichtaussendende Schicht eine Dicke von 5-20 nm aufweist.

9. Organische Leuchtdiode nach Anspruch 8, wobei die grün phosphoreszierende, lichtaussendende Schicht eine Dicke von 10 nm und die rot phosphoreszierende, lichtaussendende Schicht eine Dicke von 12 nm aufweist.

10. Organische Leuchtdiode nach Anspruch 1, ferner mit einer zwischen der Anode und der Lochtransportschicht vorgesehenen Lochinjektionsschicht und einer zwischen der Kathode und der Elektronentransportschicht vorgesehenen Elektroneninjektionsschicht.

11. Organische Leuchtdiode nach Anspruch 10, ferner mit:
einer ersten Excitoneneinschlussschicht, die eine Schicht aus einem Material ist, das in der Lage ist, Löcher zu leiten und Elektronen zu blockieren, und die zwischen der lichtaussendenden Schicht und der Lochtransportschicht vorgesehen ist; und
einer zweiten Excitoneneinschlussschicht, die eine Schicht aus einem Material ist, das in der Lage ist, Elektronen zu leiten und Löcher zu blockieren, und die zwischen der lichtaussendenden Schicht und der Elektronentransportschicht angeordnet ist.

## Revendications

1. Diode électroluminescente organique, comprenant un substrat, une anode, une couche de transport de trous, une couche émettrice de lumière, une couche de transport d'électrons, et une cathode,
la couche émettrice de lumière comprenant une première couche émettrice de lumière phosphorescente, une première couche d'isolation, une couche émettrice de lumière fluorescente bleue, une deuxième couche d'isolation, et une deuxième couche émettrice de lumière phosphorescente, lesquelles sont empilées dans cet ordre selon un sens de l'anode vers la cathode ;
la première couche d'isolation étant une couche de matière qui est apte à conduire des trous et à bloquer des électrons et qui est réalisée en 4,4',4"-tris(carbazol-9-yl)-triphénylamine (TCTA), et la deuxième couche d'isolation étant une couche de matière qui est apte à conduire des électrons et à bloquer des trous et qui est réalisée en tris-(8-hydroxyquinoléine)aluminium (AIQ) ; et
la première couche d'isolation présentant une épaisseur de 8 nm, et la deuxième couche d'isolation présentant une épaisseur de 5 nm.

2. Diode électroluminescente organique selon la revendication 1, la couche émettrice de lumière fluorescente bleue étant une couche de matière émettrice de lumière organique de 4,4'-bis(2,2-diphénylvinyl)biphényle (DPVBi).

3. Diode électroluminescente organique selon la revendication 2, la couche émettrice de lumière fluorescente bleue présentant une épaisseur dans la plage de 5 nm à 20 nm.

4. Diode électroluminescente organique selon la revendication 3, la couche émettrice de lumière fluorescente bleue présentant une épaisseur de 10 nm.

5. Diode électroluminescente organique selon la revendication 1, la première et deuxième couches émettrice de lumière phosphorescente étant de la même couleur ou de couleurs différentes.

6. Diode électroluminescente organique selon la revendication 5, la première et deuxième couches émettrice de lumière phosphorescente étant des couches émettrices de lumière phosphorescentes jaunes ou des couches émettrices de lumière phosphorescentes rouges ; ou
la première et deuxième couches émettrice de lumière phosphorescente étant une couche émettrice de lumière phosphorescente rouge et une couche émettrice de lumière phosphorescente verte, respectivement ; ou
la première et deuxième couches émettrice de lumière phosphorescente étant une couche émettrice de lumière phosphorescente verte et une couche émettrice de lumière phosphorescente rouge, respectivement.

7. Diode électroluminescente organique selon la revendication 6,
la couche émettrice de lumière phosphorescente verte étant une couche de matière organique obtenue par dopage d'un matériau invité de tris(2-phénylpyridine)iridium (Ir(ppy)₃) en un matériau de base de 4,4'-N,N'-dicarbazol-biphényle (CBP) selon un rapport molaire de 8% ; et
la couche émettrice de lumière phosphorescente rouge étant une couche de matière organique obtenue par dopage d'un matériau invité de tris(2-phénylquinoléine)iridium (Ir(2-phq)₃) en un matériau de base de 4,4'-N,N'-dicarbazol-biphényle (CBP) selon un rapport molaire de 8%.

8. Diode électroluminescente organique selon la revendication 7, la couche émettrice de lumière phosphorescente verte présentant une épaisseur de 5 à 20 nm, et la couche émettrice de lumière phosphorescente rouge présentant une épaisseur de 5 à 20 nm.

9. Diode électroluminescente organique selon la revendication 8, la couche émettrice de lumière phosphorescente verte présentant une épaisseur de 10 nm, et la couche émettrice de lumière phosphorescente rouge présentant une épaisseur de 12 nm.

10. Diode électroluminescente organique selon la revendication 1, comprenant en outre une couche d'injection de trous prévue entre l'anode et la couche de transport de trous, et une couche d'injection d'électrons prévue entre la cathode et la couche de transport d'électrons.

11. Diode électroluminescente organique selon la revendication 10, comprenant en outre :
une première couche d'inclusion d'excitons qui est une couche de matière qui est apte à conduire des trous et à bloquer des électrons et qui est prévue entre la couche émettrice de lumière et la couche de transport de trous ; et
une deuxième couche d'inclusion d'excitons qui est une couche de matière qui est apte à conduire des électrons et à bloquer des trous et qui est agencée entre la couche émettrice de lumière et la couche de transport d'électrons.
